(19) Europäisches Patentamt
European Patent Office
Office européen des brevets

(11) **EP 4 129 896 A1**

(12) **EUROPEAN PATENT APPLICATION**
published in accordance with Art. 153(4) EPC

(43) Date of publication:
**08.02.2023 Bulletin 2023/06**

(51) International Patent Classification (IPC):
***C01B 19/04*** (1980.01)     ***H01L 35/16*** (1974.07)

(21) Application number: **21774921.7**

(52) Cooperative Patent Classification (CPC):
**C01B 19/04; H01L 35/16**

(22) Date of filing: **22.03.2021**

(86) International application number:
**PCT/JP2021/011715**

(87) International publication number:
**WO 2021/193534 (30.09.2021 Gazette 2021/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.03.2020 JP 2020057017**

(71) Applicant: **Mitsubishi Materials Corporation Tokyo 100-8117 (JP)**

(72) Inventors:
- **ARAI Koya**
  **Saitama-shi, Saitama 330-8508 (JP)**
- **WIRASERANEE Chompunoot**
  **Iwaki-shi, Fukushima 971-8101 (JP)**
- **NAKAYAMA Shota**
  **Iwaki-shi, Fukushima 971-8101 (JP)**

(74) Representative: **Hoffmann Eitle Patent- und Rechtsanwälte PartmbB Arabellastraße 30 81925 München (DE)**

(54) **THERMOELECTRIC CONVERSION MATERIAL, THERMOELECTRIC CONVERSION ELEMENT, AND THERMOELECTRIC CONVERSION MODULE**

(57)    There is provided a thermoelectric conversion material containing Cu and Se as main components, an element M including one or two or more elements selected from Group 10 elements and Group 11 elements excluding Cu, and optional element of Te. The thermoelectric conversion material is represented by the following chemical formula.

Chemical Formula:    $Cu_xSe_{(1-y)}Te_yM_z,$

$$1.95 \leq x < 2.05, 0 \leq y \leq 0.1, 0.002 \leq z \leq 0.03.$$

FIG. 1

EP 4 129 896 A1

**Description**

TECHNICAL FIELD

The present invention relates to a thermoelectric conversion material containing Cu and Se as main components, a thermoelectric conversion element made of the thermoelectric conversion material, and a thermoelectric conversion module.

Priority is claimed on Japanese Patent Application No. 2020-057017, filed March 27, 2020, the content of which is incorporated herein by reference.

BACKGROUND ART

A thermoelectric conversion element made of a thermoelectric conversion material is an electronic element that enables mutual conversion between heat and electricity by the Seebeck effect and the Peltier effect. The Seebeck effect is a phenomenon in which an electromotive force is generated when a temperature difference is generated between both ends of the thermoelectric conversion material, and the thermal energy is converted into electric energy. Such electromotive force is determined by the characteristics of the thermoelectric conversion material. In recent years, thermoelectric power generation utilizing this effect has been actively developed.

The above-described thermoelectric conversion element has a structure in which electrodes are each formed on one end side and the other end side of the thermoelectric conversion material.

As an indicator that indicates the characteristics of such a thermoelectric conversion element (a thermoelectric conversion material), for example, a power factor (PF) represented by Expression (1) is used.

$$PF = S^2\sigma \ ... \ (1)$$

Here, S: Seebeck coefficient (V/K), $\sigma$: electrical conductivity (S/m)

As the above-described thermoelectric conversion material, for example, copper selenide containing Cu and Se as main components has been proposed as shown in Patent Documents 1 to 4.

[Citation List]

[Patent Documents]

[Patent Document 1]
Japanese Patent No. 6216064
[Patent Document 2]
Japanese Patent No. 6266099
[Patent Document 3]
Japanese Patent No. 6460351
[Patent Document 4]
Japanese Patent No. 6460352

SUMMARY OF INVENTION

Technical Problem

By the way, in thermoelectric conversion materials used in low voltage and high current applications, low electrical resistivity is required. However, in a case where the electrical resistivity is decreased, the Seebeck coefficient and the power factor (PF) are decreased, and thus there is a risk that the thermoelectric conversion efficiency is decreased.

The present invention has been made in consideration of the above-described circumstances, and an object of the present invention is to provide a thermoelectric conversion material having a low electrical resistivity, a sufficiently high power factor, and excellent thermoelectric conversion efficiency, as well as a thermoelectric conversion element and a thermoelectric conversion module, in which this thermoelectric conversion material is used.

Solution to Problem

In order to solve the above problems, the thermoelectric conversion material of the present invention is characterized by containing Cu and Se as main components; an element M including one or two or more elements selected from Group 10 elements and Group 11 elements excluding Cu; and optional element of Te, where the thermoelectric conversion material is represented by the following chemical formula,

Chemical Formula: $\quad\quad Cu_xSe_{(1-y)}Te_yM_z$

$$1.95 \leq x < 2.05$$

$$0 \leq y \leq 0.1$$

$$0.002 \leq z \leq 0.03.$$

According to the thermoelectric conversion material having this configuration, since the thermoelectric conversion material contains, in addition to Cu and Se, an element M including one or two or more elements selected from Group 10 elements (Ni, Pt, Pd, and the like) and Group 11 elements (Au, Ag, and the like) excluding Cu, and further contains Te, as necessary, the electrical resistivity is decreased. However, the Seebeck coefficient is not decreased more than necessary. As a result, the power factor (PF), which is an indicator of the thermoelectric conversion efficiency, is excellent, and the thermoelectric conversion efficiency is high even in low voltage and high current applications.

Here, in the thermoelectric conversion material of the present invention, it is preferable that the following expressions are satisfied in the above chemical formula,

$$1.95 \leq x < 2.05$$

$$0.05 \leq y \leq 0.1$$

$$0.002 \leq z \leq 0.01.$$

In this case, the electrical resistivity is further decreased, and the power factor (PF) is excellent since the followings are satisfied in the above chemical formula; $1.95 \leq x < 2.05$, $0.05 \leq y \leq 0.1$, and $0.002 \leq z \leq 0.01$.

The thermoelectric conversion element of the present invention is characterized by including the thermoelectric conversion material described above and electrodes each joined to a first surface and a second surface of the thermoelectric conversion material.

According to the thermoelectric conversion element having this configuration, since the thermoelectric conversion material having a low electrical resistivity and an excellent power factor (PF) is provided, the thermoelectric conversion performance is stable, whereby the reliability is excellent in low voltage and high current applications.

The thermoelectric conversion module of the present invention is characterized by including the thermoelectric conversion element described above and terminals each joined to the electrodes of the thermoelectric conversion element.

According to the thermoelectric conversion module having this configuration, since the thermoelectric conversion element described above is provided, the electrical resistivity is low, the power factor (PF) is excellent, and the thermoelectric conversion performance is stable, whereby the reliability is excellent in low voltage and high current applications.

Advantageous Effects of Invention

According to the present invention, it is possible to provide a thermoelectric conversion material having a low electrical resistivity, a sufficiently high power factor, and excellent thermoelectric conversion efficiency, as well as a thermoelectric conversion element and a thermoelectric conversion module, in which this thermoelectric conversion material is used.

BRIEF DESCRIPTION OF DRAWINGS

Fig. 1 is a cross-sectional view of a thermoelectric conversion material, a thermoelectric conversion element, and a thermoelectric conversion module according to an embodiment of the present invention.
Fig. 2 is a graph showing the relationship between electrical resistivity and the temperature in Examples.
Fig. 3 is a graph showing the relationship between the Seebeck coefficient and the temperature in Examples.
Fig. 4 is a graph showing the relationship between the power factor and the temperature in Examples.

DESCRIPTION OF EMBODIMENTS

Hereinafter, a thermoelectric conversion material, a thermoelectric conversion element, and a thermoelectric conversion module according to an embodiment of the present invention will be described with reference to the attached drawings. Each embodiment to be described below is specifically described for a better understanding of the gist of the invention and does not limit the present invention unless otherwise specified. In addition, in the drawings used in the following description, for convenience, a portion that is the main part may be enlarged in some cases in order to make the features of the present invention easy to understand, and the dimensional ratio or the like of each component is not always the same as an actual one.

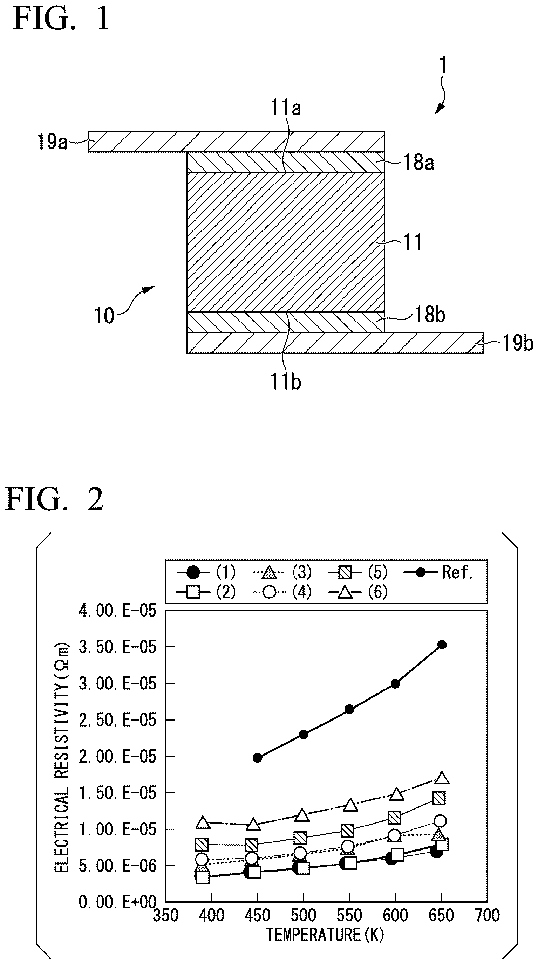

Fig. 1 shows a thermoelectric conversion material 11 according to an embodiment of the present invention, a thermoelectric conversion element 10 using the thermoelectric conversion material 11, and a thermoelectric conversion module 1.
The thermoelectric conversion element 10 includes a thermoelectric conversion material 11 according to the present embodiment, and electrodes 18a and 18b formed on a first surface 11a and a second surface 11b of the thermoelectric conversion material 11.
Further, the thermoelectric conversion module 1 includes terminals 19a and 19b each joined to the electrodes 18a and 18b of the thermoelectric conversion element 10 described above.
Nickel, silver, cobalt, tungsten, molybdenum, or the like is used in the electrodes 18a and 18b. The electrodes 18a and 18b can be formed by energized sintering, plating, electrodeposition, or the like.
The terminals 19a and 19b are formed of a metal material having excellent conductivity, for example, a plate material such as copper or aluminum. In the present embodiment, a rolled aluminum plate is used. Further, the thermoelectric conversion element 10 (the electrodes 18a and 18b) can be joined to the terminals 19a and 19b with an Ag joining material or solder by Ag brazing, or by Ag plating, Au plating, or the like of the electrodes 18a and 18b.
In addition, the thermoelectric conversion material 11 according to the present embodiment contains Cu and Se as main components and further contains optional element of Te, and an element M including one or two or more elements selected from Group 10 elements and Group 11 elements excluding Cu,
where the thermoelectric conversion material is represented by the following chemical formula,

Chemical Formula: $Cu_xSe_{(1-y)}Te_yM_z$

$$1.95 \leq x < 2.05$$

$$0 \leq y \leq 0.1$$

$$0.002 \leq z \leq 0.03.$$

Here, in the thermoelectric conversion material 11 according to the present embodiment, it is preferable that x, y, and z in the above chemical formula are each in the following range.

$$1.95 \leq x < 2.05$$

$$0.05 \leq y \leq 0.1$$

$$0.002 \leq z \leq 0.01.$$

That is, the thermoelectric conversion material 11 according to the present embodiment contains copper selenide ($Cu_2Se$) that contains a trace amount of an element M including one or two or more elements selected from Group 10 elements and Group 11 elements excluding Cu, and optional element of Te.

Since trace amounts of the element M and Te are contained, the electrical resistivity is decreased. Further, even in a case where trace amounts of the element M and Te are added to copper selenide ($Cu_2Se$), the power factor is not significantly affected.

Here, in a case of setting x to $1.95 \leq x < 2.05$ in the above chemical formula, it is possible to secure the basic characteristics as a thermoelectric conversion material made of copper selenide.

In addition, in a case of setting y to $0 \leq y \leq 0.1$, preferably $0.05 \leq x \leq 0.1$ in the above chemical formula, it is possible to secure the basic properties as a thermoelectric conversion material made of copper selenide even in a case where a part of Se is replaced with Te.

Further, in a case of setting z to $0.002 \leq z \leq 0.03$, preferably $0.002 \leq z \leq 0.01$ in the above chemical formula, it is possible to decrease the electrical resistivity without decreasing the Seebeck coefficient more than necessary.

The thermoelectric conversion material 11 according to the present embodiment can be produced by weighing and mixing each of a Cu raw material, a Se raw material, a Te raw material, and a raw material containing the element M, and sintering the obtained mixture. It is noted that a Cu raw material or a Se raw material, which contains the element M and Te, may be used since trace amounts of the element M and Te are to be contained.

According to the thermoelectric conversion material 11 according to the present embodiment having such a configuration as described above, since the thermoelectric conversion material contains, in addition to Cu and Se, an element M including one or two or more elements selected from Group 10 elements and Group 11 elements excluding Cu, and further contains Te, as necessary, the electrical resistivity is decreased. However, the Seebeck coefficient is not decreased more than necessary. As a result, the power factor (PF), which is an indicator of the thermoelectric conversion efficiency, is excellent, and the thermoelectric conversion efficiency is high even in low voltage and high current applications.

Further, in the present embodiment, the electrical resistivity is further decreased, and the power factor (PF) is excellent in a case where the following expressions are satisfied in the above chemical formula; $1.95 \leq x < 2.05$, $0.05 \leq y \leq 0.1$, and $0.002 \leq z \leq 0.01$.

Although the embodiment of the present invention has been described above, the present invention is not limited thereto and can be appropriately modified without departing from the technical idea of the invention.

For example, in the present embodiment, although a description has been made such that a thermoelectric conversion module having a structure as shown in Fig. 1 is constituted, the present embodiment is not limited to this, and in a case where the thermoelectric conversion material of the present invention is used, there are no particular limitations on the structure and arrangement of electrodes or terminals.

[Examples]

Hereinafter, the results of experiments carried out to confirm the effect of the present invention will be described.

As shown in Table 1, a Cu raw material, a Se raw material, a Te raw material, and a raw material containing the element M were weighed and mixed.

Specifically, copper selenide ($Cu_2Se$), a compound containing Te, and a compound containing the element M were used to obtain a mixture satisfying the composition shown in Table 1.

It is noted that in Present Invention Examples 1 to 3, a compound containing Pd and Ag was used as the raw material containing the element M, and in Present Invention Examples 4 to 6, a compound containing Ag was used as the raw material containing the element M.

The obtained mixture was pressed to be pelletized at 4 GPa for 1 minute with a hand press and subjected to primary sintering using a tube furnace. The conditions for the primary sintering were a sintering temperature of 100°C to 200°C in an Ar atmosphere and a holding time of 3 hours at the sintering temperature. Then, the obtained sintered body was weighed and subjected to secondary sintering using a tube furnace. The conditions for the secondary sintering were a sintering temperature of 850°C in an Ar atmosphere and a holding time of 3 hours at the sintering temperature.

Finally, the obtained sintered body was cut to a predetermined size using a diamond band saw, and the surface of the cut sintered body was polished with sandpaper of various grit size. As a result, a thermoelectric conversion material having the composition shown in Table 1 was obtained.

The electrical resistivity R, the Seebeck coefficient, and the power factor PF at various temperatures were evaluated for the thermoelectric conversion material obtained as described above. The evaluation results are shown in Figs. 2 to 4.

In Figs. 2 to 4, (1) is Present Invention Example 1, (2) is Present Invention Example 2, (3) is Present Invention Example 3, (4) is Present Invention Example 4, and (5) is Present Invention Example 5, (6) is Present Invention Example 6, and Ref. is the comparative example.

The electrical resistivity R and the Seebeck coefficient S were measured by ZEM-3 manufactured by ADVANCE RIKO, Inc.

The power factor (PF) was determined according to Expression (1).

$$PF = S^2/R \dots (1)$$

Here, S: Seebeck coefficient (V/K), R: electrical resistivity ($\Omega \cdot m$)

[Table 1]

| | Composition (atomic%) | | | | $Cu_xSe_{(1-y)}Te_yM_z$ | | |
|---|---|---|---|---|---|---|---|
| | Cu | Se | Te | Element M | x | y | z |
| Present Invention Example 1 | 66.1 | 32.9 | 0.10 | 0.84 | 2.0 | 0.003 | 0.025 |
| Present Invention Example 2 | 66.1 | 33.0 | 0.00 | 0.85 | 2.0 | 0.000 | 0.026 |
| Present Invention Example 3 | 66.0 | 33.0 | 0.00 | 0.99 | 2.0 | 0.000 | 0.030 |
| Present Invention Example 4 | 66.7 | 31.0 | 2.23 | 0.08 | 2.0 | 0.067 | 0.002 |
| Present Invention Example 5 | 66.7 | 30.7 | 2.49 | 0.09 | 2.0 | 0.075 | 0.003 |
| Present Invention Example 6 | 66.8 | 31.0 | 2.06 | 0.09 | 2.0 | 0.062 | 0.003 |
| Comparative Example | 66.7 | 33.3 | 0.00 | 0.00 | 2.0 | 0.000 | 0.000 |

In Figs. 2 to 4, Present Invention Examples 1 to 6 are shown as (1) to (6), and the comparative example is shown as "Ref.".

As shown in Fig. 2, in Present Invention Examples 1 to 6, containing an element M including one or two or more elements selected from Group 10 elements (Ni, Pt, Pd, and the like) and Group 11 elements (Au, Ag, and the like) excluding Cu and containing Te, as necessary, the electrical resistivity is sufficiently decreased as compared with the comparative example which does not contain the element M and Te.

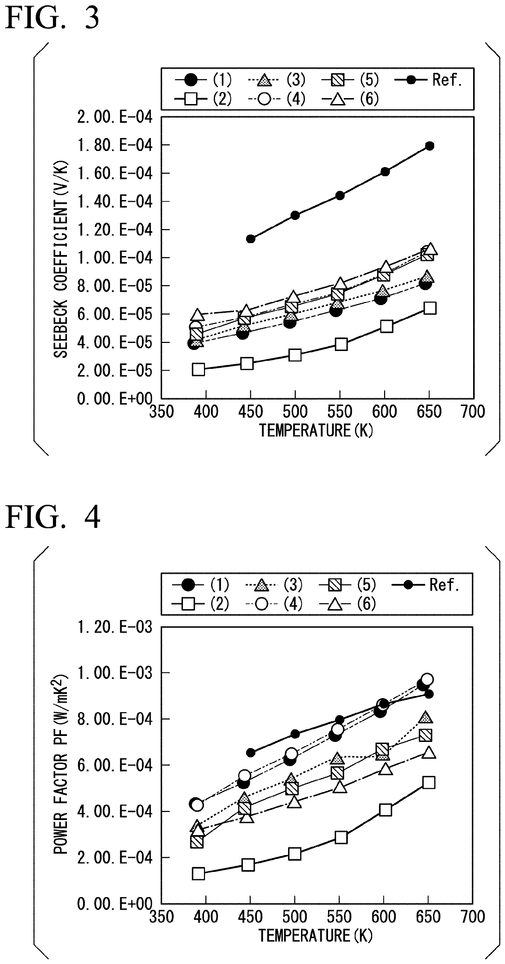

Further, as shown in Fig. 3, in Present Invention Examples 1 to 6, the Seebeck coefficient is decreased as compared with the comparative example. However, as shown in Fig. 4, there is no significant difference in the power factor (PF).

From the above, it has been confirmed that according to the present invention examples, it is possible to provide a thermoelectric conversion material having a low electrical resistivity, a sufficiently high power factor, and excellent thermoelectric conversion efficiency, as well as a thermoelectric conversion element and a thermoelectric conversion module, in which this thermoelectric conversion material is used.

[Reference Signs List]

1: Thermoelectric conversion module
10: Thermoelectric conversion element
11: Thermoelectric conversion material
18a, 18b: Electrode
19a, 19b: Terminal

**Claims**

1. A thermoelectric conversion material comprising:

   Cu and Se as main components;
   an element M including one or two or more elements selected from Group 10 elements and Group 11 elements excluding Cu; and
   optional element of Te,
   wherein the thermoelectric conversion material is represented by the following chemical formula,

   Chemical Formula: $Cu_xSe_{(1-y)}Te_yM_z$

   $$1.95 \leq x < 2.05$$

   $$0 \leq y \leq 0.1$$

   $$0.002 \leq z \leq 0.03.$$

2. The thermoelectric conversion material according to Claim 1,
   wherein in the chemical formula, the following expressions are satisfied,

   $$1.95 \leq x < 2.05$$

   $$0.05 \leq y \leq 0.1$$

   $$0.002 \leq z \leq 0.01.$$

3. A thermoelectric conversion element comprising:

   the thermoelectric conversion material according to Claim 1 or 2; and
   electrodes each joined to a first surface of the thermoelectric conversion material and a second surface facing the first surface.

4. A thermoelectric conversion module comprising:

   the thermoelectric conversion element according to Claim 3; and
   terminals each joined to the electrodes of the thermoelectric conversion element.

# FIG. 1

# FIG. 2

## FIG. 3

## FIG. 4

## INTERNATIONAL SEARCH REPORT

| | International application No. |
|---|---|
| | PCT/JP2021/011715 |

A.   CLASSIFICATION OF SUBJECT MATTER
C01B 19/04(2006.01)i; H01L 35/16(2006.01)i
FI: H01L35/16; C01B19/04 B; C01B19/04 A

According to International Patent Classification (IPC) or to both national classification and IPC

B.   FIELDS SEARCHED

Minimum documentation searched (classification system followed by classification symbols)
C01B19/04; H01L35/16

Documentation searched other than minimum documentation to the extent that such documents are included in the fields searched
   Published examined utility model applications of Japan      1922–1996
   Published unexamined utility model applications of Japan   1971–2021
   Registered utility model specifications of Japan         1996–2021
   Published registered utility model applications of Japan   1994–2021

Electronic data base consulted during the international search (name of data base and, where practicable, search terms used)
   JSTPlus/JST7580 (JDreamIII)

C.   DOCUMENTS CONSIDERED TO BE RELEVANT

| Category* | Citation of document, with indication, where appropriate, of the relevant passages | Relevant to claim No. |
|---|---|---|
| X<br>Y | WO 2019/171915 A1 (SUMITOMO ELECTRIC INDUSTRIES, LTD.) 12 September 2019 (2019-09-12) paragraph [0065] | 1<br>2-4 |
| X<br>Y | JP 2017-500726 A (LG CHEM, LTD.) 05 January 2017 (2017-01-05) paragraphs [0037]-[0104], fig. 1-11 | 1<br>2-4 |
| Y | JP 2017-500728 A (LG CHEM, LTD.) 05 January 2017 (2017-01-05) paragraphs [0030]-[0088], fig. 1-7 | 2-4 |
| Y | JP 2016-9779 A (PANASONIC IP MANAGEMENT CO., LTD.) 18 January 2016 (2016-01-18) paragraphs [0011]-[0017], fig. 1-3 | 3-4 |
| A | WO 2019/181142 A1 (SUMITOMO ELECTRIC INDUSTRIES, LTD.) 26 September 2019 (2019-09-26) entire text, all drawings | 1-4 |

☐   Further documents are listed in the continuation of Box C.    ☒   See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
|---|---|
| 04 June 2021 (04.06.2021) | 15 June 2021 (15.06.2021) |

| Name and mailing address of the ISA/<br>   Japan Patent Office<br>   3-4-3, Kasumigaseki, Chiyoda-ku,<br>   Tokyo 100-8915, Japan | Authorized officer<br><br>Telephone No. |

Form PCT/ISA/210 (second sheet) (January 2015)

**EP 4 129 896 A1**

| | INTERNATIONAL SEARCH REPORT | International application No. | |
|---|---|---|---|
| | Information on patent family members | PCT/JP2021/011715 | |

| Patent Documents referred in the Report | Publication Date | Patent Family | Publication Date |
|---|---|---|---|
| WO 2019/171915 A1 | 12 Sep. 2019 | (Family: none) | |
| JP 2017-500726 A | 05 Jan. 2017 | US 2016/0218267 A1 paragraphs [0044]-[0111], fig. 1-11 WO 2015/057019 A1 EP 3029747 A1 KR 10-2015-0044794 A KR 10-2015-0044806 A TW 201535805 A CN 105556688 A | |
| JP 2017-500728 A | 05 Jan. 2017 | US 2016/0225971 A1 paragraphs [0036]-[0097], fig. 1-7 WO 2015/057000 A1 EP 3038175 A1 KR 10-2015-0044805 A TW 201527206 A CN 105612625 A | |
| JP 2016-9779 A | 18 Jan. 2016 | (Family: none) | |
| WO 2019/181142 A1 | 26 Sep. 2019 | WO 2019/180999 A1 | |

Form PCT/ISA/210 (patent family annex) (January 2015)

**EP 4 129 896 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020057017 A
- JP 6216064 B
- JP 6266099 B
- JP 6460351 B
- JP 6460352 B